# FASCICULE DE BREVET EUROPEEN

(11) **EP 0 625 769 B1**
(45) Date de publication et mention de la délivrance du brevet: **02.09.1998**
(21) Numéro de dépôt: 94410033.8
(22) Date de dépôt: 11.05.1994
(51) Int. Cl.: G08C 19/26, H03K 7/06

(54) **Circuit de transmission d'une tension sensiblement continue, avec isolement galvanique entre l'entrée et la sortie**
Übertragungsschaltung für eine wesentliche Gleichspannung mit galvanischer Trennung zwischen Eingang und Ausgang
Transmission circuit for a substantially direct voltage with galvanic isolation between input und output

(30) Priorité: 17.05.1993 FR 9306024
(43) Date de publication de la demande: 23.11.1994
(73) Titulaire: MGE-UPS SYSTEMS, 38240 Meylan (FR)
(72) Inventeur: Gadreau, Jean, F-38050 Grenoble Cedex 09 (FR)
(74) Mandataire: Jouvray, Marie-Andrée

(56) Documents cités:
- DE-A- 2 232 450
- US-A- 3 800 300
- US-A- 3 924 251
- PATENT ABSTRACTS OF JAPAN vol. 12, no. 106 (E-596) 6 Avril 1988 & JP-A-62 236 205 (NEC CORP) 16 Octobre 1987

## Description

L'invention définie dans les revendications concerne un circuit de transmission d'une tension sensiblement continue, comportant un oscillateur, des moyens de couplage optoélectronique, constituant un isolement galvanique entre une entrée et une sortie du circuit de transmission et connectés à une sortie de l'oscillateur, et un premier circuit de détermination de valeur moyenne connecté à la sortie des moyens de couplage électronique.

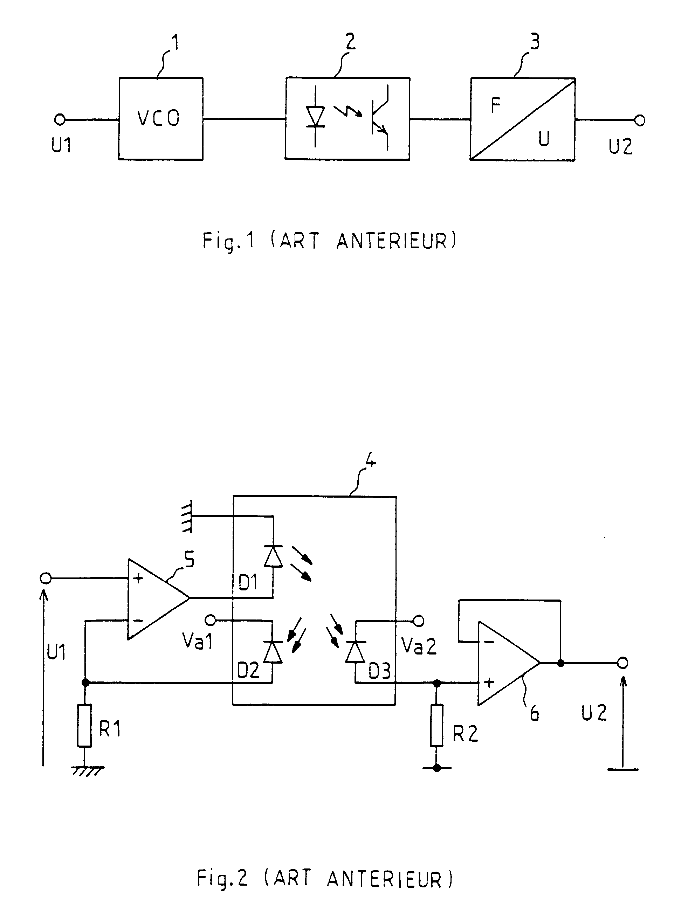

Diverses techniques sont utilisées jusqu'ici pour transmettre avec isolement galvanique, une tension continue. Le document US-A-3 924 251 mentionne la transmission d'une valeur mesurée sous forme de séquence d'impulsions. Selon une première technique, on utilise un capteur à effet Hall, ce qui s'avère relativement coûteux. Selon une seconde technique connue, représentée à la figure 1, une tension continue d'entrée U1, à transmettre, est appliquée à l'entrée d'un oscillateur commandé en tension (VCO) 1. La sortie de l'oscillateur 1 est connectée à l'entrée d'un organe de couplage optoélectronique qui assure l'isolement galvanique entre l'entrée et la sortie du circuit de transmission. Un convertisseur fréquence-tension 3 est connecté à la sortie de l'organe de couplage optoélectronique 2 et fournit une tension de sortie continue U2 représentative de la tension continue d'entrée U1. Un tel circuit est coûteux, en particulier en raison de l'utilisation d'un oscillateur commandé en tension et d'un convertisseur fréquence-tension, complexe. De plus, pour obtenir une bonne précision, il est nécessaire d'utiliser des éléments, résistances, condensateurs et oscillateur, de précision et d'effectuer un réglage de l'ensemble.

La figure 2 illustre une troisième technique, qui utilise un composant photocoupleur à bifurcation 4 du commerce. Le composant 4 comporte une diode électroluminescente D1 et deux photodiodes D2 et D3 identiques. La photodiode D2 est disposée dans une boucle de contre-réaction de manière à asservir le courant dans la diode D1 à la tension d'entrée U1 d'un amplificateur opérationnel 5. Sur la figure 2, la tension d'entrée U1 est appliquée entre la masse du circuit d'entrée et une entrée non-inverseuse de l'amplificateur opérationnel 5. La diode D1 est connectée entre la sortie de l'amplificateur 5 et la masse du circuit d'entrée. La photodiode D2 est connectée entre une tension d'alimentation Va1 et l'entrée inverseuse de l'amplificateur 5. Une résistance R1 connecte l'entrée inverseuse de l'amplificateur 5 à la masse du circuit d'entrée. La photodiode D3 est connectée entre une tension d'alimentation Va2 et une entrée non-inverseuse d'un amplificateur opérationel 6. Une résistance R2 est connectée entre l'entrée non-inverseuse de l'amplificateur 6 et la masse du circuit de sortie, isolée par rapport à la masse du circuit d'entrée. L'entrée inverseuse de l'amplificateur 6 est connectée à la sortie de l'amplificateur 6. On obtient ainsi en sortie de l'amplificateur 6 une tension U2 représentative de la tension d'entrée U1 et isolée galvaniquement par rapport à celle-ci. La précision de ce composant est liée essentiellement à l'appairage de D2 et D3. On obtient couramment +/- 5%. Le circuit nécessite un réglage pour obtenir une meilleure précision.

Dans le document DE-A-2.232.450, un signal binaire fourni par un oscillateur est représentatif du signal d'entrée à transmettre. Il est appliqué à l'entrée d'un circuit de transmission dont la sortie est connectée à un circuit RC. Le circuit RC fournit une valeur moyenne de signal binaire. Comme dans les autres circuits antérieurs, un étalonnage de l'ensemble est indispensable.

L'invention a pour but un circuit de transmission à la fois bon marché et ne nécessitant pas de réglage particulier pour obtenir une bonne précision, par exemple de l'ordre de 1%.

Selon l'invention, ce but est atteint par le fait qu'il comporte un second circuit de détermination de valeur moyenne connecté à la sortie de l'oscillateur et fournissant des signaux représentatifs de la valeur moyenne des signaux de sortie de l'oscillateur, des moyens d'asservissement de ladite valeur moyenne à la tension sensiblement continue à transmettre, un premier circuit de calibration connecté entre le second circuit de détermination de valeur moyenne et le point de connexion de l'oscillateur aux moyens de couplage optoélectronique, et un second circuit de calibration connecté entre la sortie des moyens de couplage optoélectronique et le premier circuit de détermination de valeur moyenne.

Selon un développement de l'invention, les moyens d'asservissement comportent des moyens de comparaison connectés à l'entrée du circuit de transmission et à une sortie du second circuit de détermination de valeur moyenne, une sortie des moyens de comparaison étant connectée à une entrée de contrôle de rapport cyclique de l'oscillateur.

Afin de modifier son rapport cyclique, l'oscillateur peut fournir des signaux ayant une première valeur (amplitude) prédéterminée pendant une première période fixe et une seconde valeur prédéterminée, différente de la première, pendant une seconde période de durée proportionnelle à l'amplitude d'un signal appliqué sur l'entrée de contrôle de l'oscillateur.

Chaque circuit de calibration comporte de préférence deux semi-conducteurs connectés en série entre une tension de référence et une masse associée, une entrée du circuit de calibration étant connectée à des entrées de contrôle des semiconducteurs et une sortie du circuit de calibration étant connectée au point commun des semi-conducteurs.

D'autres avantages et caractéristiques ressortiront plus clairement de la description qui va suivre d'un mode de réalisation particulier de l'invention, donné à titre d'exemple non limitatif et représenté aux dessins annexés sur lesquels :

Les figures 1 et 2 illustrent deux circuits selon l'art antérieur, décrits ci-dessus.

La figure 3 représente un schéma-bloc d'un circuit selon l'invention.

La figure 4 illustre plus en détail un mode de réalisation particulier du circuit selon la figure 3.

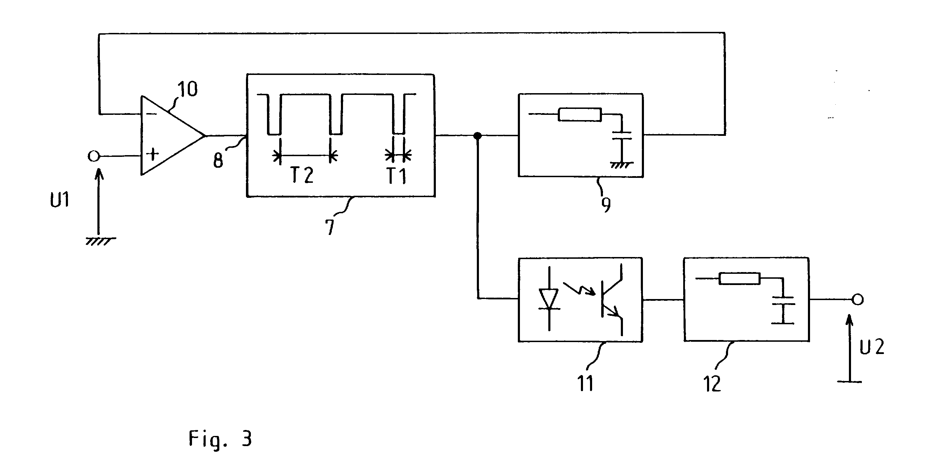

Le circuit représenté à la figure 3 comporte un oscillateur 7 fournissant des signaux oscillants dont l'amplitude oscille entre deux valeurs, basse et haute, prédéterminées. Dans le mode de réalisation représenté les signaux prennent la valeur basse pendant une première période T1 prédéterminée, fixe, et la valeur haute pendant une seconde période T2 de durée proportionnelle à l'amplitude d'une tension appliquée sur une entrée de contrôle 8 de l'oscillateur 7.

Le rapport cyclique des signaux oscillants fournis par l'oscillateur est ainsi proportionnel à la tension de contrôle appliquée à son entrée.

La sortie de l'oscillateur 7 est connectée à l'entrée d'un second circuit 9 de détermination de valeur moyenne. La sortie du circuit 9 est connectée à une entrée inverseuse d'un amplificateur opérationnel 10. La tension continue U1 à transmettre est appliquée sur l'entrée non-inverseuse de l'amplificateur opérationnel 10.

La sortie de l'oscillateur 7 est ainsi connectée à son entrée de contrôle 8 par une boucle de contre-réaction comportant le second circuit 9 de détermination de valeur moyenne. La valeur moyenne fournie par le second circuit 9 constitue une valeur de consigne qui est comparée par l'amplificateur opérationnel 10 à la valeur réelle U1.

La valeur moyenne des signaux de sortie de l'oscillateur, obtenue par le circuit 9, est ainsi asservie à la tension continue U1 à transmettre.

La sortie de l'oscillateur 7 est également connectée à l'entrée d'un coupleur optoélectronique 11. La sortie du coupleur 11 est connectée à l'entrée d'un premier circuit de détermination de valeur moyenne 12. La tension U2 de sortie du circuit 12 est une tension continue représentative de la tension continue U1, dont elle est isolée galvaniquement par le coupleur 11.

L'asservissement de la valeur moyenne des signaux de sortie de l'oscillateur à la tension continue U1 à transmettre permet l'utilisation d'un oscillateur peu précis, donc bon marché. La fréquence de l'oscillateur est limitée par la caractéristique en fréquence du coupleur optoélectronique dont il faut prendre en compte les temps de commutation. A titre d'exemple non limitatif, la fréquence de l'oscillateur peut varier entre 25 et 2500 Hz, et est de préférence inférieure à 5KHz. Il est éventuellement possible de fonctionner avec une fréquence plus élevée à condition d'utiliser un optocoupleur plus performant. Le temps de réponse est alors réduit, mais le coût du circuit est alors plus élevé.

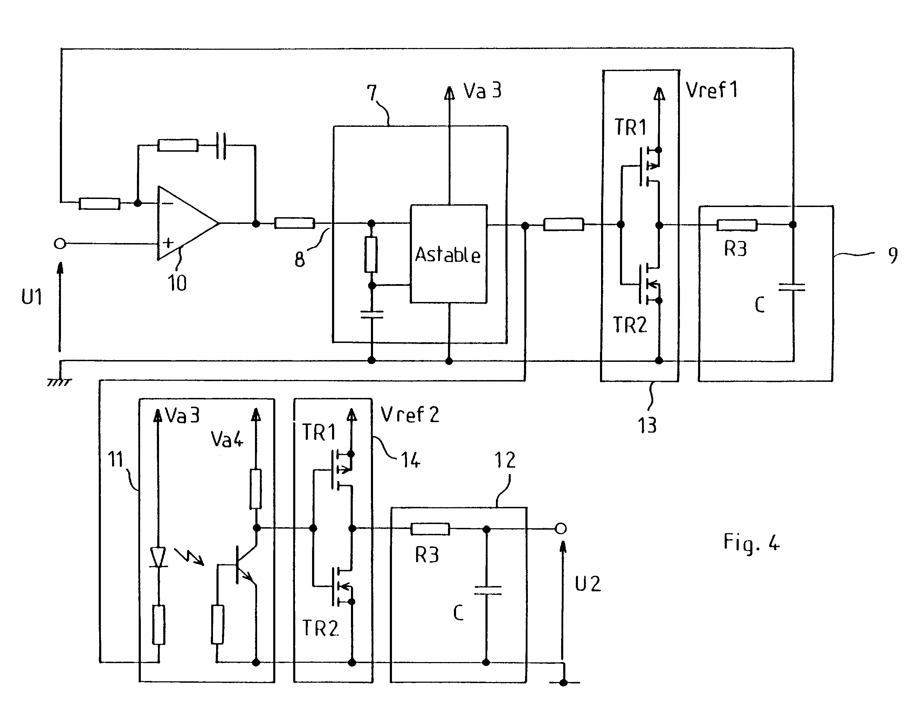

Selon un mode de réalisation préférentiel, illustré à la figure 4, un premier circuit de calibration 13 est connecté entre la sortie de l'oscillateur 7 et l'entrée du circuit 9, en aval de la connexion au coupleur 11, et un second circuit de calibration 14 est connecté entre le coupleur 11 et le circuit 12.

Chaque circuit de calibration, 13 ou 14, comporte deux transistors TR1 et TR2, de type MOS sur la figure, connectés en série entre une tension de référence associée, Vref1 ou Vref2, et la masse du circuit d'entrée ou de sortie.

Sur la figure 4, la précision du circuit est liée à la précision des tensions de références Vref1 et Vref2. Aucun étalonnage n'est nécessaire.

Si les tensions de référence sont égales, alors U2 = U1. Si elles sont distinctes alors le rapport U2/U1 est égal au rapport des tensions de référence.

Les masses des circuits d'entrée et de sortie sont isolées l'une par rapport à l'autre et il en va de même des tensions de référence Vref1 et Vref2. Les grilles des transistors TR1 et TR2 sont connectés à l'entrée du circuit de calibration et leurs drains sont connectés à la sortie du circuit de calibration. L'amplitude maximum des signaux de sortie du circuit de calibration est ainsi déterminée de façon précise par la tension de référence correspondante. La tension d'alimentation Va3 de l'oscillateur 7 et de l'élément électroluminescent du coupleur optoélectronique 11 ainsi que la tension d'alimentation Va4 de l'élément récepteur du coupleur 11 peuvent être quelconques, sans aucune précision.

Les circuits 9 et 12 de détermination de valeur moyenne sont constitués par une résistance R3 et un condensateur C connectés en série entre l'entrée du circuit de détermination de moyenne et la masse correspondante. La sortie du circuit de détermination de valeur moyenne est obtenue aux bornes du condensateur C.

L'invention n'est pas limitée au mode de réalisation particulier représenté sur les figures. En particulier, la façon d'obtenir le rapport cyclique variable des signaux de sortie de l'oscillateur peut être modifiée de toute manière appropriée. Par exemple, dans l'oscillateur, la période T1 peut être fonction de l'amplitude des signaux de contrôle de l'oscillateur et la période T2 constante. Selon une autre variante de réalisation, la période totale, T1 + T2, peut être fixe, l'une des périodes T1 ou T2 étant proportionnelle à la tension de contrôle du rapport cyclique.

L'invention réalisée avec l'oscillateur présentant la variante T1 + T2 fixe, avec des sources de tensions d'alimentation et des sources de tensions de référence à points milieux reliés à la masse permet de transmettre un signal ayant une polarité positive ou négative par rapport à la masse.

L'optocoupleur peut être remplacé par un système de transmission par fibre optique ou tout autre dispositif permettant d'obtenir un isolement galvanique approprié.

Le circuit permet de transmettre non seulement une tension continue mais également toute tension d'amplitude et fréquence lentement variables par rapport à la fréquence de l'oscillateur, pouvant ainsi être assimilée à une tension continue. En pratique, le temps de commutation du coupleur optoélectronique limite la fréquence des signaux transmis.

Le circuit de transmission est particulièrement adapté à la transmission d'une information de tension continue, de bas niveau (quelques volts), avec isolement galvanique. A titre d'exemple, il peut être utilisé pour la transmission de signaux de tension représentatifs de la tension de batterie ou du courant de charge de batterie dans une alimentation sans coupure.

## Revendications

1. Circuit de transmission d'une tension (U1) sensiblement continue, comportant un oscillateur (7), des moyens (11) de couplage optoélectronique, constituant un isolement galvanique entre une entrée (U1) et une sortie (U2) du circuit de transmission et connectés à une sortie de l'oscillateur, et un premier circuit (12) de détermination de valeur moyenne connecté à la sortie des moyens (11) de couplage optoélectronique, circuit caractérisé en ce qu'il comporte un second circuit (9) de détermination de valeur moyenne connecté à la sortie de l'oscillateur (7) et fournissant des signaux représentatifs de la valeur moyenne des signaux de sortie de l'oscillateur, des moyens (9, 10) d'asservissement de ladite valeur moyenne à la tension (U1) sensiblement continue à transmettre, un premier circuit de calibration (13) connecté entre le second circuit (9) de détermination de valeur moyenne et le point de connexion de l'oscillateur (7) aux moyens (11) de couplage optoélectronique, et un second circuit de calibration (14) connecté entre la sortie des moyens (11) de couplage optoélectronique et le premier circuit (12) de détermination de valeur moyenne.

2. Circuit selon la revendication 1, caractérisé en ce que les moyens d'asservissement comportent des moyens (10) de comparaison connectés à l'entrée (U1) du circuit de transmission et à une sortie du second circuit (9) de détermination de valeur moyenne, une sortie des moyens de comparaison (10) étant connectée à une entrée (8) de contrôle de rapport cyclique de l'oscillateur (7).

3. Circuit selon la revendication 2, caractérisé en ce que l'oscillateur (7) fournit des signaux ayant une première valeur prédéterminée pendant une première période fixe (T1) et une seconde valeur prédéterminée, différente de la première, pendant une seconde période (T2) de durée proportionnelle à l'amplitude d'un signal appliqué sur l'entrée de contrôle (8) de l'oscillateur (7).

4. Circuit selon l'une quelconque des revendications 1 à 3, caractérisé en ce que les circuits (9, 12) de détermination de valeur moyenne comportent une résistance (R3) en série avec un condensateur (C).

5. Circuit selon l'une quelconque des revendications 1 à 4, caractérisé en ce que ledit circuit de calibration (13, 14) comporte deux semi-conducteurs (TR1, TR2) connectés en série entre une tension de référence associée (Vref1, Vref2) et une masse associée, une entrée du circuit de calibration étant connectée à des entrées de contrôle des semi-conducteurs et une sortie du circuit de calibration étant connectée au point commun des semi-conducteurs.

6. Circuit selon la revendication 5, caractérisé en ce que les semiconducteurs (TR1, TR2) sont des transistors de type MOS.

7. Circuit selon l'une quelconque des revendications 1 à 6, caractérisé en ce que l'oscillateur (7) a une fréquence inférieure à 5KHz.

## Patentansprüche

1. Schaltungsanordnung zur Übertragung einer Quasi-Gleichspannung (U1) mit einem Oszillator (7), optoelektronischen Kopplungsmitteln (11), die eine galvanische Trennung zwischen einem Eingang (U1) und einem Ausgang (U2) der Übertragungsschaltung herstellen und an einen Ausgang des Oszillators angeschlossen sind, sowie einer, an den Ausgang der optoelektronischen Kopplungsmittel (11) angeschlossenen ersten Schaltung (12) zur Mittelwertbestimmung, dadurch gekennzeichnet, daß die Übertragungsschaltung eine, an den Ausgang des Oszillators (7) angeschlossene und den Mittelwert der Ausgangssignale des Oszillators abbildende Signale liefernde zweite Schaltung (9) zur Mittelwertbestimmung, Regelungsmittel (9, 10) zur Rückführung des genannten Mittelwerts auf die zu übertragende Quasi-Gleichspannung (U1), eine zwischen der zweiten Schaltung (9) zur Mittelwertbestimmung und dem Verbindungspunkt zwischen dem Oszillator (7) und den optoelektronischen Kopplungsmitteln (11) angeschlossene, erste Kalibrierschaltung (13) sowie eine, zwischen dem Ausgang der optoelektronischen Kopplungsmittel (11) und der ersten Schaltung (12) zur Mittelwertbestimmung angeschlossene zweite Kalibrierschaltung (14) umfaßt.

2. Schaltungsanordnung nach Anspruch 1, dadurch gekennzeichnet, daß die Regelungsmittel an den Eingang (U1) der Übertragungsschaltung sowie einen Ausgang der zweiten Schaltung (9) zur Mittelwertbestimmung angeschlossene Vergleichsmittel (10) umfassen, wobei ein Ausgang der Vergleichsmittel (10) an einen Steuereingang (8) zur Veränderung des Tastverhältnisses des Oszillators (7) angeschlossen ist.

3. Schaltungsanordnung nach Anspruch 2, dadurch gekennzeichnet, daß der Oszillator (7) Signale liefert, die einen bestimmten ersten Wert während einer festen ersten Zeitspanne (T1) und einen, vom ersten Wert abweichenden, bestimmten zweiten Wert während einer zweiten Zeitspanne (T2) aufweisen, deren Dauer der Amplitude eines an den Steuereingang (8) des Oszillators (7) angelegten Signals proportional ist.

4. Schaltungsanordnung nach irgendeinem der Ansprüche 1 bis 3, dadurch gekennzeichnet, daß die Schaltungen (9, 12) zur Mittelwertbestimmung einen in Reihe mit einem Kondensator (C) geschalteten Widerstand (R3) umfassen.

5. Schaltungsanordnung nach irgendeinem der Ansprüche 1 bis 4, dadurch gekennzeichnet, daß die genannte Kalibrierschaltung (13, 14) zwei zwischen einer zugeordneten Referenzspannung (Vref1, Vref2) und einem zugeordneten Massepotential in Reihe geschaltete Halbleiter (TR1, TR2) umfaßt, wobei ein Eingang der Kalibrierschaltung mit Steuereingängen der Halbleiter und ein Ausgang der Kalibrierschaltung mit dem gemeinsamen Anschlußpunkt der Halbleiter verbunden ist.

6. Schaltungsanordnung nach Anspruch 5, dadurch gekennzeichnet, daß die Halbleiter (TR1, TR2) als MOS-Transistoren ausgebildet sind.

7. Schaltungsanordnung nach irgendeinem der Ansprüche 1 bis 6, dadurch gekennzeichnet, daß die Frequenz des Oszillators (7) unter 5 kHz liegt.

## Claims

1. A circuit for transmission of an appreciably DC voltage (U1), comprising an oscillator (7), means for optoelectronic coupling (11) constituting a galvanic isolation between an input (U1) and an output (U2) of the transmission circuit and connected to an output of the oscillator, and a first circuit (12) for determining a mean value connected to the output of the optoelectronic coupling means (11), a circuit characterized in that it comprises a second circuit (9) for determining a mean value connected to the output of the oscillator (7) and supplying signals representative of the mean value of the oscillator output signals, means (9, 10) for loop-locking said mean value to the appreciably DC voltage (U1) to be transmitted, a first calibration circuit (13) connected between the second circuit (9) for determining a mean value and the connection point of the oscillator (7) to the means for optoelectronic coupling (11), and a second calibration circuit (14) connected between the output of the means for optoelectronic coupling (11) and the first circuit (12) for determining a mean value.

2. The circuit according to claim 1, characterized in that the means for loop-locking comprise means for comparison (10) connected to the input (U1) of the transmission circuit and to an output of the second circuit (9) for determining a mean value, an output of the means for comparison (10) being connected to a duty cycle control input (8) of the oscillator (7).

3. The circuit according to claim 2, characterized in that the oscillator (7) supplies signals having a first preset value during a first fixed period (T1) and a second preset value, different from the first, during a second period (T2) of a duration proportional to the amplitude of the signal applied to the control input (8) of the oscillator (7).

4. The circuit according to any one of the claims 1 to 3, characterized in that the circuits (9, 12) for determining a mean value comprise a resistor (R3) in series with a capacitor (C).

5. The circuit according to any one of the claims 1 to 4, characterized in that said calibration circuit (13, 14) comprises two semi-conductors (TR1, TR2) connected in series between an associated reference voltage (Vref1, Vref2) and an associated ground, an input of the calibration circuit being connected to control inputs of the semi-conductors and an output of the calibration circuit being connected to the common point of the semi-conductors.

6. The circuit according to claim 5, characterized in that the semi-conductors (TR1, TR2) are MOS type transistors.

7. The circuit according to any one of the claims 1 to 6, characterized in that the oscillator (7) has a frequency less than 5 KHz.
